## Europäisches Patentamt
## European Patent Office
## Office européen des brevets

(19)

(11) Veröffentlichungsnummer: **0 200 078 B1**

(12)

# EUROPÄISCHE PATENTSCHRIFT

(45) Veröffentlichungstag der Patentschrift:
25.10.89

(51) Int. Cl.⁴: **G01N 24/04, G01N 24/08**

(21) Anmeldenummer: **86105130.8**

(22) Anmeldetag: **14.04.86**

(54) Kernspin-Tomographiegerät.

(30) Priorität: **26.04.85 DE 3515190**

(43) Veröffentlichungstag der Anmeldung:
**10.12.86 Patentblatt 86/45**

(45) Bekanntmachung des Hinweises auf die Patenterteilung:
**25.10.89 Patentblatt 89/43**

(84) Benannte Vertragsstaaten:
**DE FR GB NL**

(56) Entgegenhaltungen:
**EP-A- 0 047 065**
**EP-A- 0 105 550**
**WO-A- 84/00214**
**GB-A- 2 137 757**
**US-A- 4 411 270**

(73) Patentinhaber: **Siemens Aktiengesellschaft,
Wittelsbacherplatz 2, D-8000 München 2(DE)**

(72) Erfinder: **Meissner, Ralph, Dipl.-Ing.,
Paul-Gossen-Strasse 34, D-8520 Erlangen(DE)**
Erfinder: **Popp, Walter, Dipl.-Ing., Dürrnbuch 4,
D-8535 Emskirchen(DE)**

## Beschreibung

Die Erfindung betrifft ein Kernspin-Tomographiegerät zur bildlichen Darstellung von Teilbereichen aus dem Innern eines Untersuchungsobjektes mit Spulen zum Anlegen von magnetischen Grund- und Gradientenfeldern an das Untersuchungsobjekt und einer Oberflächenspule zum Erfassen der Auslenkung der Kernspins des Untersuchungsobjektes aus ihrer Gleichgewichtslage.

Ein Gerät dieser Art, aber ohne Oberflächenspule, ist in der deutschen Patentanmeldung P 31 35 335.5 (EP-A 74 022) beschrieben. Durch dieses Gerät ist es möglich, die Kernspins eines Untersuchungsobjektes aus einer Vorzugsrichtung, die durch ein Magnet-Grundfeld erzeugt wird, durch einen hochfrequenten Anregungsimpuls auszulenken und beim Einpendeln der Kernspins nach dem Ende des Anregungsimpulses ein Signal zu erzeugen, dessen Frequenz von der Stärke des Magnet-Grundfeldes abhängt. Überlagert man dem homogenen Magnet-Grundfeld einen Feldgradienten, so daß die Magnetfeldverteilung räumlich variiert, so ist eine Ortung über die jeweils gemessene Frequenz möglich. Auf diese Weise und durch Änderung der Richtung des Feldgradienten können auch Schichtbilder des Untersuchungsobjektes erzeugt werden. Die Anregung in einer Schicht des Untersuchungsobjektes erfolgt dabei dadurch, daß das Magnet-Grundfeld durch einen weiteren Feldgradienten so beeinflußt wird, daß nur in dieser Schicht eine Anregung der Kernspins erfolgt. Dies ist möglich, weil die Anregung nur mit einer Frequenz erfolgt, die dem Magnetfeld in der gewünschten Schicht streng zugeordnet ist.

Für die Untersuchung einzelner Körperbereiche kann eine Oberflächenspule benutzt werden, bei der durch einen Anstieg im Signal/Rausch-Verhältnis die räumliche Auflösung im empfindlichen Bereich verbessert ist. Dabei kann mit einer größeren Antenne, einem sogenannten Körper-Resonator, gesendet werden, um ein homogenes Feld im Bereich der Oberflächenspule zu erzeugen. Die von den Kernen abgegebenen Signale werden dann mit der Oberflächenspule empfangen. Es ist jedoch prinzipiell auch möglich, mit einer Oberflächenspule zu senden und zu empfangen. Eine Oberflächspule dieser Art ist in WO-A 8 400 214 beschrieben.

Beim Auflegen einer Oberflächenspule auf den zu untersuchenden Körperbereich tritt eine Frequenzverstimmung auf, die durch elektrische Verluste des Gewebes verursacht wird.

Der Erfindung liegt die Aufgabe zugrunde, ein Kernspin-Tomographiegerät der eingangs genannten Art so auszubilden, daß eine vollsymmetrische Frequenzabstimmung der Oberflächenspule erfolgen kann.

Diese Aufgabe ist erfindungsgemäß dadurch gelöst, daß die Oberflächenspule ringförmig ausgebildet und an ihren Enden über je eine Kapazität mit Masse verbunden und von einem Hochfrequenzschirm umgeben ist, der über der Mitte der Oberflächenspule geschlitzt ist. Die Oberflächenspule kann dabei die Form eine Kreisringes aber auch je nach Anwendung eines ovalen, rechteckigen oder anders geformten Ringes haben. Die Frequenzverstimmung durch elektrische Verluste des Gewebes ist minimal.

Einzelheiten der Erfindung ergeben sich aus den Unteransprüchen.

Die Erfindung ist nachfolgend anhand der Zeichnung näher erläutert. Es zeigen:

Fig. 1 ein Kernspin-Tomographiegerät zur Erläuterung des Erfindungsgedankens,

Fig. 2 eine erfindungswesentliche Einzelheit des Gerätes gemäß Figur 1, und

Fig. 3 und 4 Einzelheiten der Figur 2 in zwei verschiedenen Ansichten.

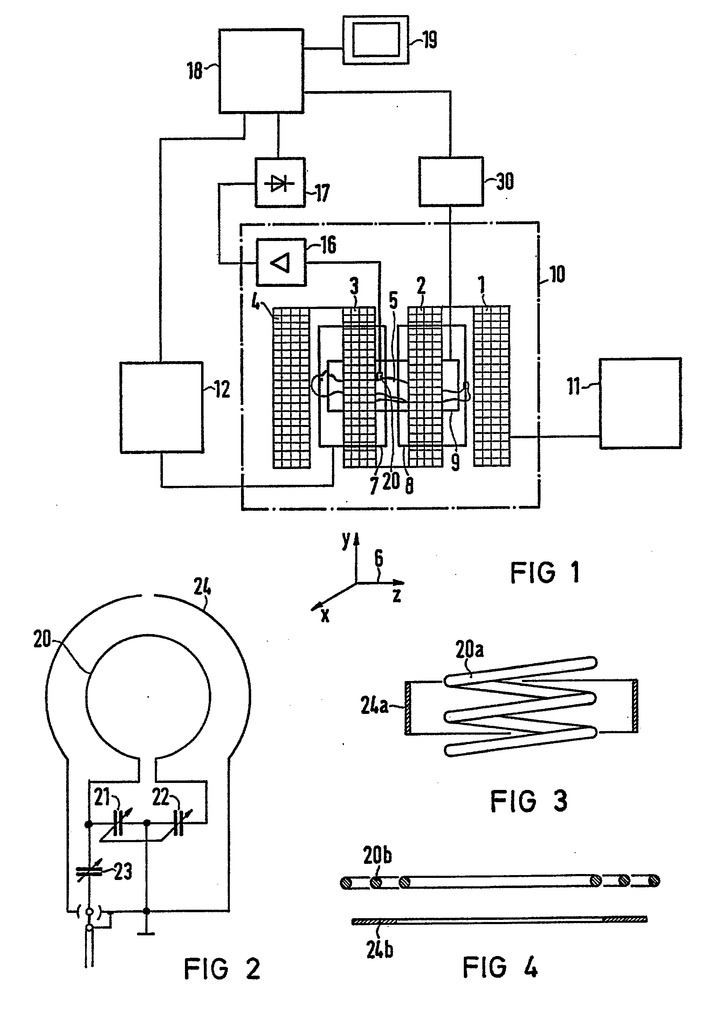

In der Figur 1 sind mit 1 und 2 sowie 3 und 4 Spulen gekennzeichnet, mit welchen ein magnetisches Grundfeld $B_0$ erzeugt wird, in welchem sich bei Anwendung zur medizinischen Diagnostik der zu untersuche Körper 5 eines Patienten befindet. Diesem sind außerdem Gradientenspulen zugeordnet, die zur Erzeugung unabhängiger, zueinander senkrechter Magnetfeldgradienten der Richtungen x, y und z gemäß der Andeutung in 6 vorgesehen sind. In der Figur 1 sind der Übersichtlichkeit halber nur Gradientenspulen 7 und 8 gezeichnet, die zusammen mit einem Paar gegenüberliegender, gleichartiger Gradientenspulen zur Erzeugung des x-Gradienten dienen. Die gleichartigen, nicht gezeichneten y-Gradientenspulen liegen parallel zum Körper 5 und oberhalb sowie unterhalb von ihm und die für das z-Gradientenfeld quer zu seiner Längsachse am Kopf- und am Fußende. Die Anordnung enthält außerdem noch eine zur Erzeugung und zum Empfang der Kernresonanzsignale dienende Spule 9.

Die von einer strichpunktierten Linie 10 umgrenzten Spulen 1 bis 9 stellen das eigentliche Untersuchungsinstrument dar. Es wird von einer elektrischen Anordnung aus betrieben, die ein Netzgerät 11 zum Betrieb der Spulen 1 bis 4 sowie eine Gradientenstromversorgung 12, an welcher die Gradientenspulen 7 und 8 sowie die weiteren Gradientenspulen liegen, umfaßt. Die zur Aufnahme des Signales dienende Oberflächenspule 20 liegt über einen Signalverstärker 16 und einen phasenempfindlichen Gleichrichter 17 an einem Prozeßrechner 18, von dem aus zur Ausgabe der Abbildung ein Bildschirmgerät 19 versorgt wird. Die Spule 9 ist ferner über einen Sender 30 ebenfalls mit dem Prozeßrechner 18 verbunden.

Aus der Figur 2 geht hervor, daß die Oberflächenspule 20 eine Spule mit nur einer Windung ist, die aus einem Kupferband der Länge kleiner

$$\frac{\lambda}{4} \, ,$$

vorzugsweise kleiner

$$\frac{\lambda}{4} \, ,$$

gebildet ist, dessen Form der entsprechenden Anwendung angepaßt ist und das insbesondere auch zur individuellen Anpassung flexibel sein kann. Die beiden Enden dieses Kupferbandes sind über gleiche, einstellbare Kapazitäten 21, 22 mit Masse verbunden. Mit den Kapazitäten 21, 22 wird die Resonanzfrequenz eingestellt. Die Hochfrequenz-Einspeisung erfolgt über eine einstellbare Kapazität 23, die mit einem Ende der Oberflächenspule 20 verbunden ist. Es ist dabei unerheblich, an welchem Ende die Kapazität 23 angeschlossen ist.

In einem Abstand von etwa einem Zehntel des Durchmessers der Oberflächenspule 20 ist ein Schirmband 24 parallel zur Oberflächenspule 20 angeordnet. Das Schirmband 24 umfaßt die Oberflächenspule 20 vollständig.

Durch die beiden gleichen Kapazitäten 21, 22 an den Spulenenden stellt sich in der Mitte des Bandes immer ein Spannungsknoten ein, d.h. an dieser Stelle fließt der maximale Strom. Hier ist das Schirmband 24 geschlitzt, denn die Abschirmwirkung für die elektrische Komponente des elektromagnetischen Feldes ist dort sehr gering. Andererseits ist eine elektrische Unterbrechung im Schirmband 24 erforderlich, da sonst die mit der Oberflächenspule 20 erzeugten magnetischen Feldlinien wieder kurzgeschlossen würden. Die von den Gradientenimpulsen erzeugten Wirbelströme werden somit auch unterdrückt.

Das Schirmband 24 wirkt den elektrischen Feldanteilen entgegen. Der kapazitive Einfluß bleibt gering, da die Länge der von einem Band gebildeten Oberflächenspule 20 sehr kurz gegenüber der Wellenlänge ist und durch die symmetrische Beschaltung in zwei gleiche Hälften zum Spannungsknoten aufgeteilt ist.

Aus der Figur 3 geht hervor, daß die als Zylinderspule ausgebildete Oberflächenspule 20a im wesentlichen einen kurzen Hohlzylinder bildet, der von dem koaxial dazu liegenden, im wesentlichen ebenfalls hohlzylindrisch ausgebildeten Schirmband 24a umschlossen ist.

Bei der Alternative gemäß Figur 4 sind die als Spiralspule ausgebildete Oberflächenspule 20b und das Schirmband 24b ebenfalls ringförmig ausgebildet, haben dieselbe Achse und liegen in Achsrichtung nebeneinander.

Die in den Figuren dargestellte, abgeschirmte Oberflächenspule kann in das Meßfeld gebracht werden, ohne daß sich die Abstimmung wesentlich ändert. Dadurch ist eine Vorabstimmung außerhalb der Spulen 3, 4 zur Erzeugung des Grundfeldes möglich.

Für Frequenzen größer als etwa 50 MHz sind allerdings Spulen mit mehreren Windungen ungünstig, da die Eigenresonanz dieser Spulen in der Nähe der Betriebsfrequenz liegt. Eine Spule mit nur einer Windung (mit Umfangslänge

$$\approx \frac{\lambda}{8}),$$

wie sie in Verbindung mit den Figuren 2 bis 4 erläutert ist, ist hier vorteilhaft.

Bei kleinem Durchmesser der Spule sind auch zwei bis drei Windungen möglich, wenn die Länge des Spulenbandes

$$\leq \frac{\lambda}{8}$$

ist. Bei gleichen Meßbedingungen wird mit der abgeschirmten Oberflächenspule gemäß den Figuren 2 bis 4 ein besseres Signal/Rausch-Verhältnis erzielt als mit einer Oberflächenspule ohne Abschirmung. Die Frequenzverstimmung liegt unter 0,4 % der Betriebsfrequenz mit einem die Spule fast ausfüllenden Kochsalzphantom als Last. Die flache Ausführungsform gemäß den Figuren 3 und 4 erhöht bei gleicher Belastung die Resonanzfrequenz, was bedeutet, daß die Verluste durch Wirbelströme in der Last die elektrischen Verluste überwiegen.

## Patentansprüche

1. Kernspin-Tomographiegerät zur Dartstellung von Bereichen aus dem Innern eines Untersuchungsobjektes (5) mit Spulen (1 bis 8) zum Anlegen von magnetischen Grund- und Gradientenfeldern an das Unterschungsobjekt (5) und einer ringförmig ausgebildeten Oberflächenspule (20) zum Erfassen der Auslenkung der Kernspins des Untersuchungsobjektes (5) aus ihrer Gleichgewichtslage, **dadurch gekennzeichnet**, daß die Oberflächenspule (20) an ihren Enden über je eine Kapazität (21, 22) mit Masse verbunden und von einem Hochfrequenzschirm (24), der über der Mitte der Oberflächenspule (20) geschlitzt ist, überdeckt ist.

2. Kernspin-Tomographiegerät nach Anspruch 1, **dadurch gekennzeichnet**, daß mit einem Ende der Oberflächenspule (20) eine Koppelkapazität (23) für die Hochfrequenzeinspeisung verbunden ist.

3. Kernspin-Tomographiegerät nach Anspruch 1 oder 2, **dadurch gekennzeichnet**, daß die Oberflächenspule (20) von einem Metallband gebildet ist.

4. Kernspin-Tomographiegerät nach Anspruch 3, **dadurch gekennzeichnet**, daß das die Oberflächenspule (20,20a) bildende Metallband und ein den Hochfrequenzschirm (24, 24a) bildendes weiteres Metallband im wesentlichen als koaxial zueinander angeordnete, kurze Hohlzylinder ausgebildet sind.

5. Kernspin-Tomographiegerät nach Anspruch 3, **dadurch gekennzeichnet**, daß das die Oberflächenspule (20b) bildende Metallband und ein den Hochfrequenzschirm (24b) bildendes Metallband als zwei Ringe ausgebildet sind, die dieselbe Achse aufweisen und in Achsrichtung im Abstand zueinander angeordnet sind.

## Claims

1. Apparatus for nuclear-spin tomography, for the representation of internal regions of an examination subject (5), having coils (1 to 8) for applying magnetic fundamental and gradient fields to the examination subject (5), and a ring-shaped surface coil (20) for capturing the deflection of the nuclear spin of the examination subject (5) from its state of equilibrium, characterised in that the surface coil (20) is connected at each of its ends to ground by way of a capacitance (21, 22), and is covered by a high-frequency screen (24) which is split over the middle of the surface coil (20).

2. Apparatus for nuclear-spin tomography according to claim 1, characterised in that a coupling capacitance (23) for the high-frequency feed is connected to one end of the surface coil (20).

3. Apparatus for nuclear-spin tomography according to claim 1 or 2, characterised in that the surface coil (20) is formed from a metal band.

4. Apparatus for nuclear-spin tomography according to claim 3, characterised in that the metal band forming the surface coil (20, 20a) and a further metal band forming the high-frequency screen (24, 24a) are constructed substantially as short, hollow cylinder which are arranged coaxially to each other.

5. Apparatus for nuclear-spin tomography according to claim 3, characterised in that the metal band forming the surface coil (20b) and a metal band forming the high-frequency screen (24b) are constructed as two rings which have the same axis and which are arranged at a distance from each other in the axial direction.

## Revendications

1. Appareil pour la tomographie par résonance magnétique nucléaire pour la représentation de régions de l'intérieur d'un objet à examiner (5), comprenant des bobines (1 à 8) pour appliquer un champ magnétique de base et des champs magnétiques de gradients à l'objet à examiner (5) et une bobine de surface (20) de forme annulaire pour détecter la déviation des spins nucléaires de l'objet (5) à partir de leur position d'équilibre, caractérisé en ce que la bobine de surface (20) est reliée par ses extrémités à la masse, à travers une capacité (21, 22) et est recouverte par un écran haute fréquence (24) qui est fendu au-dessus du milieu de la bobine de surface (20).

2. Appareil selon la revendication 1, caractérisé en ce qu'une capacité de couplage (23) pour l'alimentation en haute fréquence est reliée à une extrémité de la bobine de surface (20).

3. Appareil selon la revendication 1 ou 2, caractérisé en ce que la bobine de surface (20) est formée par une bande métallique.

4. Appareil selon la revendication 3, caractérisé en ce que la bande métallique formant la bobine de surface (20, 20a) et une autre bande métallique, formant l'écran haute fréquence (24, 24a), sont réalisées essentiellement comme de courts cylindres creux disposés coaxialement l'un par rapport à l'autre.

5. Appareil selon la revendication 3, caractérisé en ce que la bande métallique formant la bobine de surface (20b) et une bande métallique formant l'écran haute fréquence (24b), sont réalisées comme deux anneaux qui présentent le même axe et sont disposés axialement à distance l'un de l'autre.

FIG 1

FIG 2

FIG 3

FIG 4